# EUROPÄISCHE PATENTSCHRIFT

(11) **EP 1 438 749 B1**
(45) Veröffentlichungstag und Bekanntmachung des Hinweises auf die Patenterteilung: **04.08.2010**
(21) Anmeldenummer: 02776807.6
(22) Anmeldetag: 11.10.2002
(51) Int. Cl.: H01L 27/32

(54) **ORGANISCHES ELEKTROLUMINESZIERENDES DISPLAY**
ORGANIC ELECTROLUMINESCENT DISPLAY
SYSTEME D'AFFICHAGE ELECTROLUMINESCENT ORGANIQUE

(30) Priorität: 26.10.2001 DE 10152919
(43) Veröffentlichungstag der Anmeldung: 21.07.2004
(73) Patentinhaber: OSRAM Opto Semiconductors GmbH, 93055 Regensburg (DE)
(72) Erfinder: BIRNSTOCK, Jan, 01187 Dresden (DE); BLÄSSING, Jörg, 73447 Oberkochen (DE); HEUSER, Karsten, 91056 Erlangen (DE); STÖSSEL, Matthias, 68163 Mannheim (DE); WITTMANN, Georg, 91074 Herzogenaurach (DE)
(74) Vertreter: Epping - Hermann - Fischer
(86) Internationale Anmeldenummer: PCT/DE2002/003843
(87) Internationale Veröffentlichungsnummer: WO 2003/038898

(56) Entgegenhaltungen:
- EP-A- 0 767 599
- EP-A- 0 938 248
- EP-A1- 0 996 314
- EP-A2- 1 122 793
- WO-A-01/41229
- WO-A-98/59356
- GB-A- 2 348 050
- US-A- 2001 015 626
- US-A1- 2001 026 124

## Beschreibung

Organische Leuchtdioden (OLEDs) auf der Basis von elektrolumineszierenden Polymeren haben in den letzten Jahren eine rasante Entwicklung genommen. OLEDs bestehen im Prinzip aus einer oder mehreren Schichten von elektrolumineszierenden, organischen Materialien, die zwischen zwei Elektroden gestapelt sind. Beim Anlegen einer Spannung an den Elektroden lumineszieren die Materialien.

OLEDs haben im Vergleich zu den den Markt der Flachbildschirme dominierenden Flüssigkristallanzeigen eine Reihe von Vorteilen. Zum einen zeigen sie aufgrund eines anderen physikalischen Funktionsprinzips Selbstemissivität, so daß die Notwendigkeit einer Hinterleuchtung, die in der Regel bei Flachbildschirmen auf der Basis von Flüssigkristallanzeigen gegeben ist, entfällt. Dadurch reduziert sich der Platzbedarf und die elektrische Leistungsaufnahme bei OLEDs erheblich. Die Schaltzeiten der organischen Leuchtdioden liegen im Bereich von einer Mikrosekunde und sind nur gering temperaturabhängig, was den Einsatz für Videoapplikationen ermöglicht. Im Gegensatz zu Flüssigkristallanzeigen beträgt der Ablesewinkel nahezu 180°. Polarisationsfolien, wie sie bei Flüssigkristallanzeigen erforderlich sind, entfallen zumeist, so daß eine größere Helligkeit der Anzeigeelemente erzielbar ist. Ein weiterer Vorteil ist die Verwendbarkeit flexibler und nicht planarer Substrate, sowie die einfache und kostengünstige Herstellung.

Bei den OLEDs existieren zwei Technologien, die sich in der Art und in der Verarbeitung der organischen Materialien unterscheiden. Zum einen lassen sich niedermolekulare organische Materialien, wie zum Beispiel Hydroxychinolin-Aluminium-III-salze verwenden, die zumeist durch thermisches Verdampfen auf das entsprechende Substrat aufgebracht werden. Displays auf der Basis dieser Technologie sind bereits kommerziell erhältlich und werden zur Zeit überwiegend in der Automobilelektronik eingesetzt. Da die Herstellung dieser Bauelemente mit zahlreichen Prozeßschritten unter Hochvakuum verbunden ist, birgt diese Technologie jedoch Nachteile durch hohen Investitions- und Wartungsaufwand, sowie relativ geringen Durchsatz.

Seit 1990 wurde daher eine OLED-Technologie entwickelt, die als organische Materialien Polymere verwendet, welche naßchemisch aus einer Lösung auf das Substrat aufgebracht werden können. Die zur Erzeugung der organischen Schichten erforderlichen Vakuumschritte entfallen bei dieser Technik.

In der Druckschrift EP 0 892 028 A2 ist ein Verfahren offenbart, bei dem elektrolumineszierende Polymere mittels eines Tintenstrahldruckverfahrens in die Fenster einer Fotolackschicht gedruckt werden, die einzelne Bildpunkte definieren. Der Nachteil dieser Methode besteht darin, daß Tintenstrahldruckverfahren sehr langsam sind, so daß diese Art von Produktionsverfahren sehr zeit- und damit kostenintensiv sind.

Die Druckschrift EP 0 996 314 A1 offenbart ein Verfahren, bei dem organische elektrolumineszierende Schichten mittels Aufdampfen aufgebracht werden. Die einzelnen Bildpunkte werden mithilfe von Stegen separiert.

Aus diesem Grunde wird versucht, für das Drucken der Polymere großflächige Druckverfahren anzuwenden, die kostengünstig innerhalb kurzer Zeit eine große Fläche bedrucken können. Im Moment werden die Polymere zumeist mit Hilfe eines Drehschleuderverfahrens großflächig aufgebracht. Dieses Verfahren hat allerdings eine Reihe von Nachteilen. So geht ein Großteil der Polymerlösung (zirka 99 %) unwiederbringlich verloren, und der Drehschleudervorgang dauert zudem ebenfalls relativ lange (zirka 30 bis 60 Sekunden). Bei größeren Substraten ist es nahezu unmöglich Polymerschichten mit homogener Dicke aufzubringen.

Prinzipiell eignen sich eine ganze Reihe von anderen großflächigen Standarddruckverfahren für das Drucken von elektrolumineszierenden Polymeren, beispielsweise Flachdruckverfahren

wie der Offsetdruck, der Tampondruck oder Hoch- und Tiefdruckverfahren, wie beispielsweise der Flexodruck. In der Druckschrift WO 99 07189 A1 werden eine Reihe von Standarddruckverfahren für das Aufbringen von elektrolumineszierenden Polymeren offenbart.

Häufig tritt bei diesen großflächigen Druckverfahren jedoch ein anderes Problem auf. Die Polymere sind nicht auf Verdruckbarkeit optimiert, sondern auf eine optimale Leistung bezüglich Sperrverhältnis, Lebensdauer und Elektrolumineszenz -Effizienz. Dies bedeutet, daß beim Drucken der Polymere auf Substraten Schwierigkeiten auftreten, die man von klassischen Druckfarben nicht kennt oder die durch Modifizierung dieser klassischen Druckfarben, beispielsweise durch Zusetzen von Additiven beseitigt werden können. Eine dieser Schwierigkeiten ist das Verlaufen der Polymere nach dem Druck auf dem Substrat. Anstelle von scharfen Rändern erhält man je nach Druckverfahren und Anwendung sehr breite "verschmierte Randzonen". Die Option, die Polymerlösung durch Zusetzen von Additiven drucktauglich zu machen, besteht in den allermeisten Fällen nicht, da diese Zusätze die Effizienz der Polymere beeinträchtigen.

Durch ein Verlaufen der Polymerlösung während des Druckens wird die Dicke der Polymerschicht vor allem an den äußeren Bildpunkten des Displays reduziert, was zu inhomogenem Leuchten und einer verminderten Lebensdauer des Displays führt. Weiterhin werden häufig Elektrodenanschlüsse beispielsweise aus einem oxidationsresistenten, elektrisch leitfähigem Material wie Indium-Zinn-Oxid (ITO) unter einer Abdeckung hindurchgeführt, die die empfindlichen Polymere, sowie das oxidationsempfindliche Kathodenmaterial schützt. Um eine dichte Abdeckung auf dem Substrat beziehungsweise den Elektrodenanschlußstücken zu gewährleisten, ist es notwendig, daß diese Bereiche von Polymeren frei sind. Die Kathodenanschlußstücke müssen auch deshalb von Polymeren frei sein, da ansonsten die zuerst auf ein Substrat aufgebrachten Kathodenanschlußstücke von der später aufgebrachten Kathode isoliert wären. Aus diesen eben genannten Gründen ist es notwendig, daß bei großflächigen Druckverfahren ein Verlaufen der Polymere vermieden wird.

Die Aufgabe der Erfindung ist es, ein Display auf der Basis elektrolumineszierender Polymere anzugeben, das ein Verlaufen der elektrolumineszierenden Schichten beim großflächigen Aufbringen vermeidet. Diese Aufgabe wird mit einem Display nach Anspruch 1 gelöst. Vorteilhafte Ausgestaltungen des Displays, ein Aktiv-Matrix-Display sowie Verfahren zur Herstellung des Displays sind Gegenstand weiterer Ansprüche.

Bei einem erfindungsgemäßen Display ist auf einem Substrat eine erste Elektrodenschicht angeordnet. Die funktionellen Schichten des Displays, die aus organischen, elektrolumineszierenden Schichten z.B. Lochtransport- und Emitterpolymeren bestehen können, werden auf einen Bereich aufgebracht, der erfindungsgemäß von ersten, streifenförmigen Stegen begrenzt wird. Die funktionellen Schichten können dabei großflächig innerhalb dieses Bereiches angeordnet werden. Auf den funktionellen Schichten befindet sich eine zweite Elektrodenschicht, welche zumindest auf einem der ersten, streifenförmigen Stege angeordnet ist.

Da die funktionellen Schichten nur schwer auf Druckbarkeit hin optimiert werden können, wird bei dem vorliegenden erfindungsgemäßen Display das Display so modifiziert, daß erste streifenförmige Stege das Verlaufen der großflächig aufgebrachten funktionellen Schichten verhindern. Erst durch diese Stegstruktur wird es möglich, die funktionellen Schichten auf definierte Bereiche des Substrats großflächig aufzubringen und gleichzeitig einzugrenzen, so daß auch an den Rändern der funktionellen Schichten eine gleichbleibende Dicke möglich wird.

In einer vorteilhaften Ausgestaltung des Displays ist die erste Elektrodenschicht elektrisch leitend mit einem ersten Elektrodenanschlußstück verbunden. Benachbart zur ersten Elektrodenschicht befindet sich auf dem Substrat zumindest ein zweites Elektrodenanschlußstück. Die zweite Elektrodenschicht kontaktiert dann das zweite Elektrodenanschlußstück. Der Bereich der funktionellen Schichten mit den sie umgrenzenden Stegen, sowie die zweite Elektrodenschicht werden von einer Abdeckung bedeckt, die gleichzeitig jedoch ein Ende des ersten und zweiten Elektrodenanschlußstückes frei läßt.

Bei dieser vorteilhaften Variante des erfindungsgemäßen Displays ist es aufgrund der ersten streifenförmigen Stege möglich, daß die zweite Elektrodenschicht problemlos das zweite Elektrodenanschlußstück kontaktieren kann und gleichzeitig eine dichte Abdeckung des Displays aufgebracht werden kann, da keine verlaufenden funktionellen Schichten einen Kontakt zwischen der Abdeckung und dem Substrat bzw. den Elektrodenanschlußstücken behindern.

In einer weiteren vorteilhaften Ausgestaltung des erfindungsgemäßen Displays wird ein Passiv-Matrix-Display beschrieben. Bei diesem Display umfaßt die erste Elektrodenschicht zueinander parallel verlaufende erste Elektrodenstreifen, wobei die Verlängerung eines jeden Elektrodenstreifens als erstes Elektrodenanschlußstück dient. Quer zu den ersten Elektrodenstreifen sind zweite isolierende streifenförmige Stege angeordnet, die später zur Separation der zweiten Elektrodenstreifen dienen. Die ersten streifenförmigen Stege können in dieser Anordnung alleine oder zusammen mit wenigstens zwei der zweiten streifenförmigen Stege, die quer zu den ersten Stegen angeordnet sind, die funktionellen Schichten eingrenzen. Wird nach dem Erzeugen der funktionellen Schichten großflächig eine zweite Elektrodenschicht aufgebracht, so reißt der Metallfilm an den Kanten der zweiten isolierenden streifenförmigen Stege ab, so daß quer zu den ersten Elektrodenstreifen zweite Elektrodenstreifen gebildet werden, die beidseitig von je einem Steg der zweiten isolierenden Stege begrenzt werden. Diese zweiten Elektrodenstreifen kontaktieren jeweils ein auf das Substrat aufgebrachtes zweites Elektrodenanschlußstück. Im vorliegenden Passiv-Matrix-Display wird eine Matrix einzeln ansteuerbarer Bildpunkte erhalten, wobei die Bildpunkte durch die Kreuzungspunkte der ersten und zweiten Elektrodenstreifen definiert werden. Die ersten Elektrodenstreifen fungieren in der Regel als Anoden, während die zweiten Elektrodenstreifen als Kathode eingesetzt werden. Legt man an jeweils einen Anoden- und Kathodenstreifen eine Spannung an, so leuchtet der Pixel, der als Kreuzungspunkt dieser Elektrodenstreifen definiert ist.

Im Falle des erfindungsgemäßen Passiv-Matrix-Displays ist es prinzipiell möglich, daß beispielsweise zwei erste isolierende Stege die quer zu den zweiten isolierenden Stegen angeordnet sind, zusammen mit wenigstens zwei der zweiten isolierenden Stege die funktionellen Schichten 20 eingrenzen. Weiterhin ist es möglich, daß die ersten isolierenden Stege so angeordnet sind, daß wenigstens zwei von ihnen quer und zwei weitere Stege längs zu den zweiten isolierenden Stegen für die Separation der Kathode verlaufen, wobei die vier ersten isolierenden Stege zusammen die funktionellen Schichten eingrenzen. Da häufig mehrschichtige funktionelle Schichten verwendet werden, die beispielsweise aus polaren oder unpolaren Polymeren, wie Lochtransport oder Emitterpolymeren bestehen, ist es beispielsweise auch möglich, daß die erste isolierende Stegstruktur von einer weiteren isolierenden Stegstruktur eingegrenzt wird, wobei beide Stegstrukturen unterschiedliche Benetzbarkeit für polare und unpolare funktionelle Schichten aufweisen können. Die ersten isolierenden Stege zur Eingrenzung der funktionellen Schichten und die zweiten isolierenden Stege zur Kathodenseparation können aber auch aus dem gleichen Material ausgebildet sein.

Im Falle eines Passiv-Matrix-Displays können die ersten und zweiten isolierenden Stege vorteilhafterweise aus dem gleichen Material ausgebildet sein. Dies hat den Vorteil, daß die ersten isolierenden Stege für die Abgrenzung der funktionellen Schichten in einem Verfahrensschritt mit den Stegen zur Kathodenseparation ausgebildet werden können. Als Materialien sind beispielsweise positive oder negative Fotolacke, oder andere isolierende, schichtbildende Materialien beispielsweise Siliziumdioxid geeignet.

Die zweiten isolierenden Stege zur Separation der Kathode weisen vorteilhafterweise eine nach oben hin überhängende Kantenform auf, so daß der später großflächig aufgebrachte Metallfilm (zweite Elektrodenschicht) zuverlässig an den Kanten der zweiten isolierenden Stege abreißt. Werden die ersten isolierenden Stege zur Begrenzung der funktionellen Schichten gemeinsam mit den zweiten isolierenden Stegen aufgebracht, so weisen auch diese in der Regel überhängende Kantenformen auf. In diesem Falle ist es vorteilhaft, daß wenigstens derjenige erste isolierende Steg quer zu den zweiten isolierenden Stegen, der zu den zweiten Elektrodenanschlußstücken (Kathodenanschlußstücken) benachbart ist, aus wenigstens zwei nicht miteinander verbundenen Bereichen ausgebildet ist. Dies hat den Vorteil, daß trotz der überhängenden Kantenformen der ersten isolierenden Stege aufgrund deren unterbrochener Stegstruktur ein Abreißen des zweiten Elektrodenfilms an der Grenze zu den Elektrodenanschlußstücken beim großflächigen Aufbringen zuverlässig verhindert wird, so daß die zweiten Elektrodenstreifen mit den zweiten Elektrodenanschlußstücken elektrisch kontaktiert sind.

Gegenstand der Erfindung ist auch ein Verfahren, das die Erzeugung einer ersten Elektrodenschicht im Verfahrensschritt A) vorsieht. Eine erste isolierende Schicht kann auf das Substrat und/oder die erste Elektrodenschicht aufgebracht und anschließend zu ersten streifenförmigen Stegen in einem Verfahrensschritt B) strukturiert werden. Dabei ist es auch möglich, daß zuerst die ersten streifenförmigen Stege und anschließend die erste Elektrodenschicht erzeugt wird, also zuerst Verfahrensschritt B) und dann A) durchgeführt wird. Anschließend werden in einem Verfahrensschritt C) die funktionellen Schichten großflächig auf den durch die ersten streifenförmigen Stege eingegrenzten Bereich aufgebracht und danach in einem Verfahrensschritt D) großflächig eine zweite Elektrodenschicht auf den funktionellen Schichten erzeugt.

Im folgenden soll das erfindungsgemäße Display sowie dessen Herstellungsverfahren anhand von Ausführungsbeispielen und Figuren näher erläutert werden.
- Figuren 1A bis 1D: zeigen die Herstellung eines herkömmlichen Displays mit nicht strukturierten ersten und zwei- ten Elektrodenschichten.
- Figuren 2A bis 2E: zeigen die Herstellung einer Variante eines erfindungsgemäßen Displays mit nicht strukturierten ersten und zweiten Elektrodenschichten und Elektro- denanschlußstücken.
- Die Figuren 3A bis 3F: zeigen die Herstellung eines erfin- dungsgemäßen Passiv-Matrix-Displays mit struktu- rierten ersten und zweiten Elektrodenstreifen.
- Die Figuren 4A bis 4K: zeigen herkömmliche zweite streifenför- mige Stege zur Strukturierung der Kathode (zweite Elektrodenstreifen) und erfindungsgemäße Kombina- tionen aus den zweiten streifenförmigen Stegen und den ersten streifenförmigen Stegen zur Abgrenzung der funktionellen Schichten.
- Figuren 5A und 5B: zeigen eine Möglichkeit, mit einer Kombina- tion aus den ersten und zweiten streifenförmigen Stegen funktionelle Schichten voneinander abgren- zen, die verschiedenfarbige Elektrolumineszenz zei- gen.
- Die Figuren 6A und 6B: zeigen die Querschnitte von Stegen ohne und mit überhängenden Kantenformen.

- Die Figur 7: zeigt ein erfindungsgemäßes Aktiv-Matrix-Display.

Um die Unterschiede zwischen einem herkömmlichen und einem erfindungsgemäßen Display beziehungsweise deren Herstellungsverfahren zu verdeutlichen, soll im folgenden kurz auf ein Herstellungsverfahren für ein herkömmliches Display mit nicht strukturierten ersten und zweiten Elektrodenschichten und Elektrodenanschlußstücken z.B. für Beleuchtungsanwendungen, eingegangen werden.

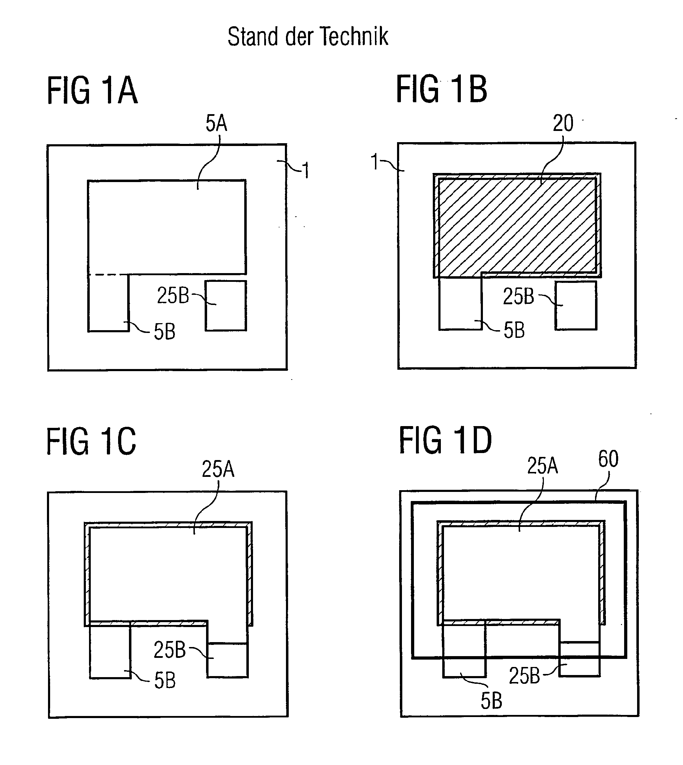

Bei einem herkömmlichen Herstellungsverfahren wird in einem ersten Verfahrensschritt wie in Figur 1A gezeigt, auf einem transparenten Substrat 1, beispielsweise einer Glasscheibe eine erste Elektrodenschicht 5A mit einem direkt elektrisch verbundenen ersten Elektrodenanschlußstück 5B, sowie einen elektrisch davon isolierten zweiten Elektrodenanschlußstück 25B erzeugt. Als Material für die Elektrodenschicht wird üblicherweise Indium-Zinn-Oxid (ITO) als elektrisch leitendes transparentes Material eingesetzt.

In Figur 1B wird in einem zweiten Verfahrensschritt großflächig eine Schicht funktioneller Polymere (20) aufgetragen. Die funktionelle Schicht 20 sollte dabei keine Bereiche des zweiten Elektrodenanschlußstückes 25B sowie des ersten Elektrodenanschlußstückes 5B bedecken, da diese Bereiche unter einer später aufzubringenden Verdeckung hindurchgeführt werden und im Falle des Vorhandenseins von funktionellen Schichten auf diesen Anschlußstücken keine dichte Abdeckung mehr möglich wäre. Desweiteren ist darauf zu achten, daß die funktionellen Schichten 20 auch keine anderen Bereiche auf dem Substrat 1 bedecken, auf denen später die Abdeckung angebracht wird.

In einem nächsten Verfahrensschritt (Figur 1C) wird anschließend großflächig zum Beispiel mit Hilfe einer Schattenmaske die zweite Elektrodenschicht 25A, beispielsweise bestehend aus Aluminium, aufgebracht, wobei darauf zu achten ist, daß diese zweite Elektrodenschicht in Kontakt mit dem zweiten Elektrodenanschlußstück 25b steht.

In einem letzten Verfahrensschritt wird, wie in Figur 1D gezeigt, eine Abdeckung 60 über die Bereiche der funktionellen Schichten und der sie bedeckenden zweiten Elektrodenschicht angebracht, wobei beide Elektrodenanschlußstücke 5B und 25B unter der Abdeckung hindurchgeführt werden.

Im Gegensatz zu dem gezeigten herkömmlichen Herstellungsverfahren für ein Display, zeichnet sich eine Variante des erfindungsgemäßen Herstellungsverfahrens, die im folgenden erläutert wird, durch wenigstens einen zusätzlichen Verfahrensschritt aus, bei dem streifenförmige Stege zur Abgrenzung der funktionellen Schichten aufgebracht werden. Diese Variante umfaßt auch zusätzlich die Erzeugung von ersten und zweiten Elektrodenstreifen sowie die Anbringung einer Verkapselung. In seiner allgemeinsten Form umfaßt das erfindungsgemäße Verfahren, wie bereits oben erwähnt, nur die Verfahrensschritte A) bis D), wobei weder Elektrodenanschlußstücke noch eine Verkapselung erzeugt werden.

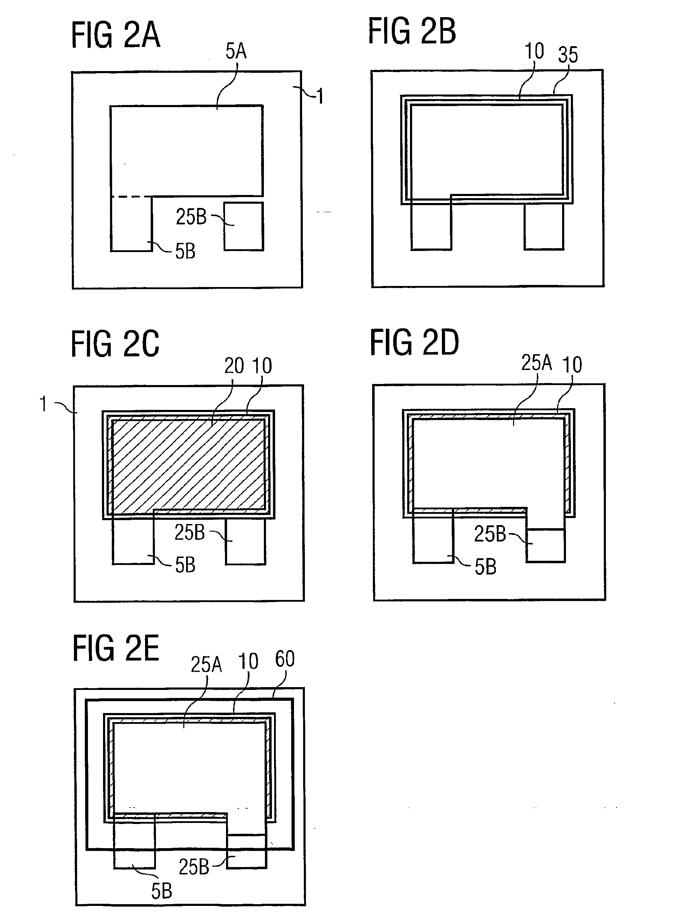

Die Variante des erfindungsgemäßen Verfahrens ist dadurch gekennzeichnet, daß in einem ersten Verfahrensschritt A), wie in Figur 2A gezeigt, auf einem Substrat 1 eine erste Elektrodenschicht 5A mit einem ersten Elektrodenanschlußstück 5B und daneben zumindest ein zweites Elektrodenanschlußstück 25B erzeugt werden. Auch in diesem Falle wird üblicherweise als transparentes, elektrisch leitendes Elektrodenmaterial Indium-Zinn-Oxid (ITO) verwendet. Dieses läßt sich leicht mit flüssigem HBr strukturieren.

In einem zweiten Verfahrensschritt B) wird auf das Substrat und/oder die Elektrodenschicht eine erste isolierende Schicht aufgebracht und anschließend so zu streifenförmigen Stegen 10 strukturiert, daß diese den Bereich eingrenzen, auf dem später funktionelle Schichten 20 erzeugt werden sollen. Dieser Verfahrensschritt ist in Figur 2B gezeigt, wobei vorteilhafterweise die ersten isolierenden streifenförmigen Stege 10 von vorzugsweise parallel dazu verlaufenden, weiteren streifenförmigen Stegen 35 umgeben sind, die aus anderen Materialien bestehen können als die ersten streifenförmigen Stege 10, so daß es möglich ist, durch die beiden Stegstrukturen 10 und 35 mehrere unterschiedliche funktionelle Schichten eingrenzen, von denen eine Schicht beispielsweise hydrophil und die andere Schicht hydrophob ist In diesem Fall ist es dann möglich, daß die erste funktionelle Schicht von den ersten streifenförmigen Stegen 10 und die zweite funktionelle Schicht von der Stegstruktur 35 begrenzt werden.

In einem Verfahrensschritt C) werden anschließend, wie in Figur 2C gezeigt, die funktionellen Schichten 20 großflächig aufgebracht, wobei wie bereits erwähnt auch mehrere Schichten aufgebracht werden können.

In einem anschließend Verfahrensschritt D) wird großflächig eine zweite Elektrodenschicht 25A auf den funktionellen Schichten 20 so erzeugt, daß sie das zweite Elektrodenanschlußstück 25B kontaktiert. Dieser Verfahrensschritt ist in Figur 2D gezeigt. Die zweite Elektrodenschicht läßt sich beispielsweise durch eine Schattenmaske großflächig aufdampfen.

In einem letzten Verfahrensschritt E) wird abschließend wie in Figur 2E gezeigt, eine Abdeckung 60 so angebracht, daß sie den Bereich der funktionellen Schichten 20 und der sie eingrenzenden Stege 10 und 35, die zweite Elektrodenschicht 25A und jeweils ein Ende des ersten und zweiten Elektrodenanschlußstückes bedeckt. Das Material der Abdeckung kann beispielsweise einen Kunststoff umfassen.

Der Vorteil dieser Variante des erfindungsgemäßen Verfahrens besteht darin, daß aufgrund der erfindungsgemäßen ersten streifenförmigen Stege 10 die großflächig aufgebrachten funktionellen Schichten 20 begrenzt werden, so daß es problemlos möglich ist, eine Abdeckung 60 anzubringen, die dicht mit dem transparenten Substrat 1 und den Elektrodenanschlußstücken 5B und 25B abschließt, da sich auf diesen Bereichen keine verlaufenden funktionellen Schichten befinden, die eine dichte Verkapselung verhindern würden.

Im folgenden wird ein Verfahren zur Herstellung eines erfindungsgemäßen Passiv-Matrix-Displays mit strukturierten ersten und zweiten Elektrodenstreifen, sowie einer Matrix einzeln ansteuerbarer Bildpunkte beschrieben.

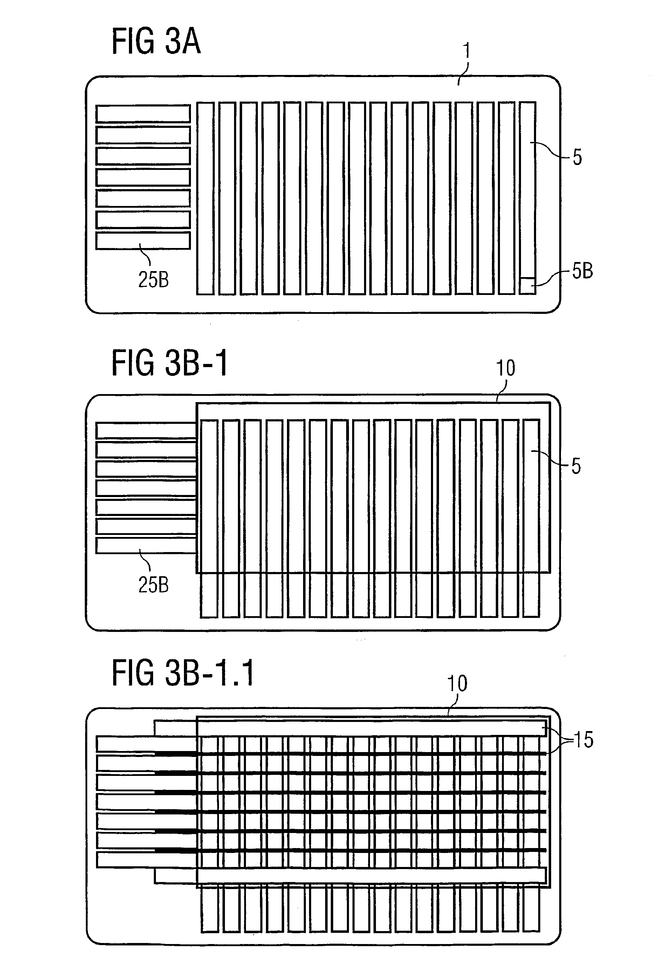

Bei diesem Verfahren wird im Verfahrensschritt A) wie in Figur 3A gezeigt, die erste Elektrodenschicht 5A zu zueinander parallel verlaufenden ersten Elektrodenstreifen 5 strukturiert, wobei die Verlängerung eines jeden Elektrodenstreifens 5 als erstes Elektrodenanschlußstück 5B fungiert. Benachbart zu einem der äußeren Elektrodenstreifen 5 sind die zweiten Elektrodenanschlußstücke 25B angeordnet.

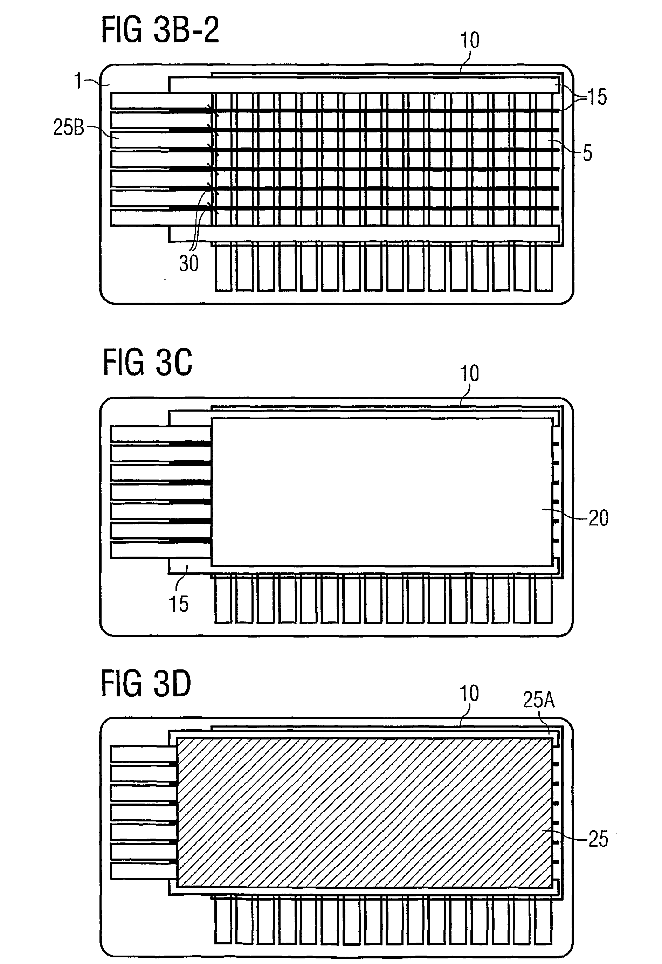

Da bei diesen Verfahren auch zweite streifenförmige Stege 15 zur Strukturierung der zweiten Elektrodenstreifen (Kathodenstreifen) auf dem Substrat angeordnet werden, ist es möglich, die ersten streifenförmigen Stege 10 zur Eingrenzung der funktionellen Schichten in einem Verfahrenschritt B) aufzubringen, wie in Figur 3B-1 gezeigt und getrennt davon die zweiten streifenförmigen Stege 15 in einem separaten Verfahrensschritt B1), wie in Figur 3B-1.1 gezeigt zu strukturieren. Dabei ist es möglich, daß die zweiten streifenförmigen Stege vor oder nach den ersten streifenförmigen Stegen erzeugt werden. Diese Verfahrensweise hat den Vorteil, daß nach der Strukturierung von einem der beiden streifenförmigen Stegen 10 oder 15, dieser durch eine zusätzliche Behandlung seiner Oberfläche modifiziert werden kann. Beispielsweise bietet sich an, eine der beiden streifenförmigen Stegstrukturen gegenüber einer Benetzung mit Lösungsmitteln zu passivieren, indem man sie in einem fluorierenden Plasma beispielsweise CF₄ ätzt. Möglich ist auch, die Stege mit grenzflächenaktiven Stoffen, beispielsweise Tensiden oder Detergentien zu behandeln. Auf diese Weise können die Stegstrukturen in Abhängigkeit davon, ob sie von polaren oder unpolaren Lösungsmitteln der funktionellen Schichten benetzt werden sollen, vorbehandelt werden. Die chemische und mechanische Beständigkeit von Stegen, die beispielsweise aus Polyvinylalkohol bestehen, läßt sich auch dadurch verbessern, daß sie mit chemischen Härtern behandelt werden. Bei der Härtung kommt es zu einer zusätzlichen Vernetzung des Polymers, wobei sich auch das Benetzungsverhalten der Stege ändert.

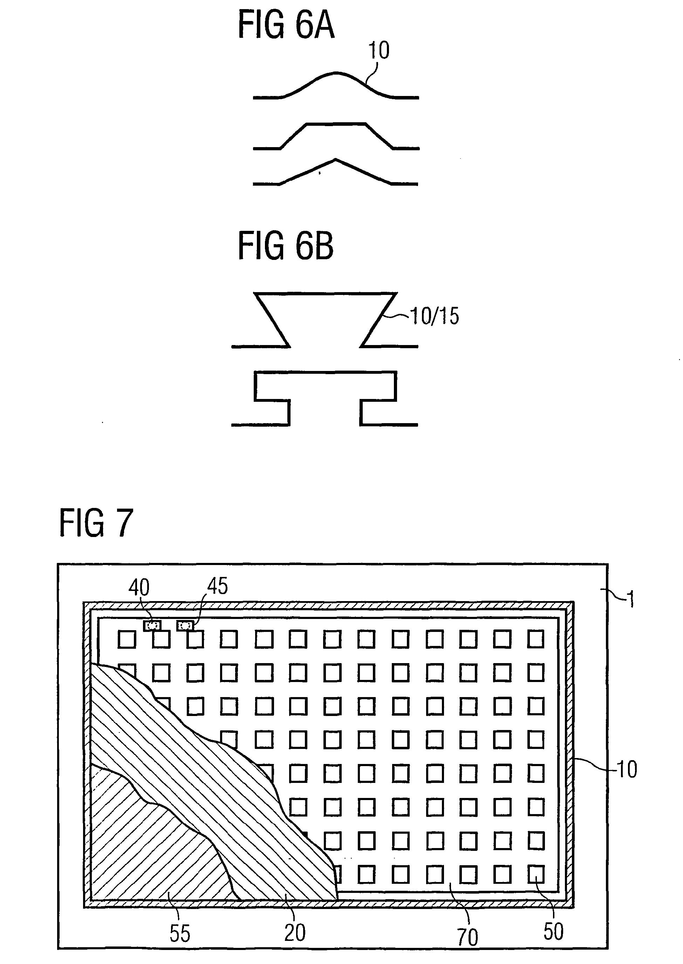

Die zusätzliche Modifizierung der Oberfläche einer der beiden isolierenden Stege, sowie ihre separate Strukturierung und Aufbringung unabhängig von den anderen isolierenden Stegen, hat den Vorteil, daß die beiden Stegstrukturen jeweils individuell ihrer Problemstellung angepaßt werden können (erste isolierende Stege = Abgrenzung der funktionellen Schichten, zweite isolierende Stege = Separation der Kathodenstreifen). Durch die separate Strukturierung der beiden Stegstrukturen kann unter anderem auch die Form und die Dimensionierung jeder Stegstruktur ganz individuellen Gegebenheiten angepaßt werden. So können die zweiten isolierenden Stege beispielsweise mit überhängenden Kanten strukturiert werden, wie in Fig. 6B gezeigt, an denen dann beim späteren Aufbringen der zweiten Elektrodenschicht der Metallfilm abreißen kann, während die ersten isolierenden Stege keine überhängende Kantenform aufweisen.

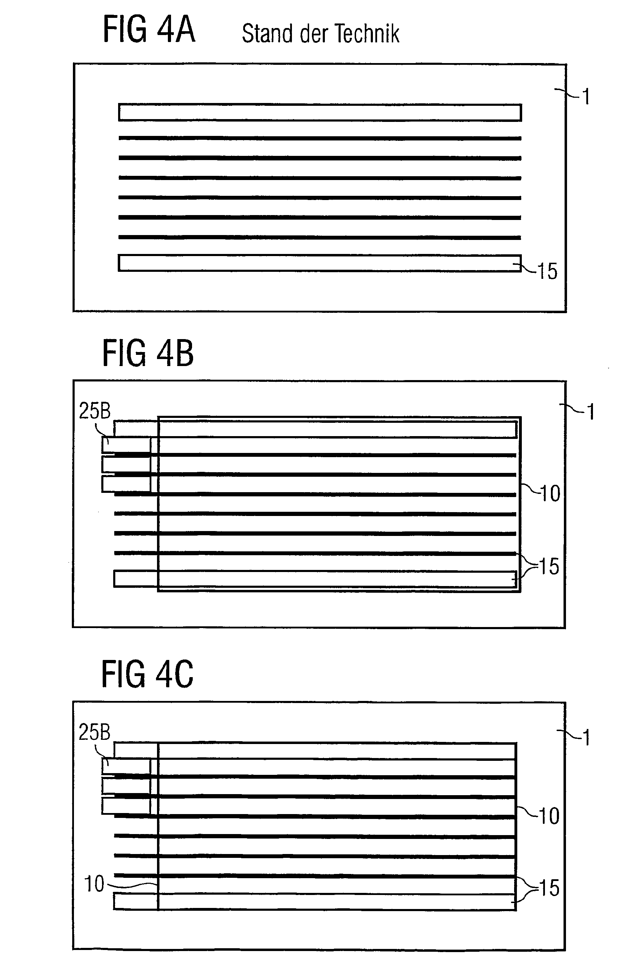

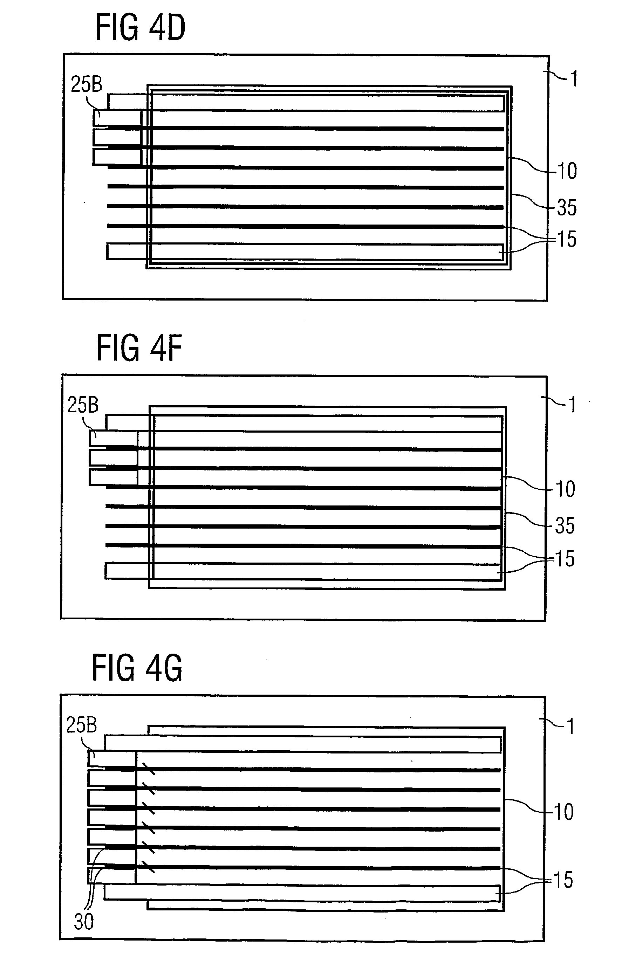

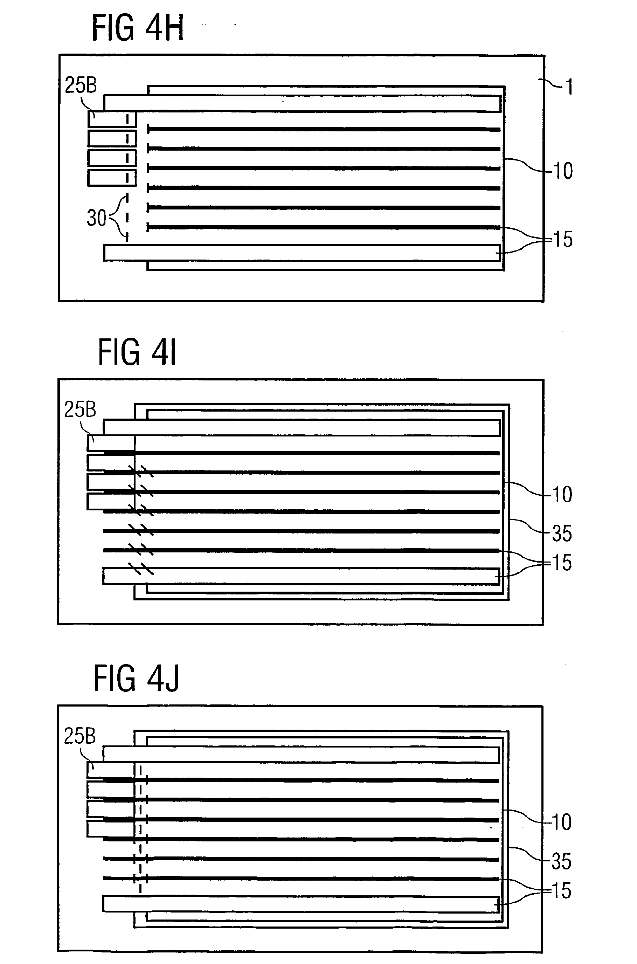

Möglich ist es allerdings auch, in einem gemeinsamen Verfahrensschritt B) die ersten und zweiten streifenförmigen Stege aus dem gleichen Material zu fertigen und gemeinsam zu strukturieren. Dies hat den Vorteil, daß sie in einem einzigen Verfahrensschritt schnell und kostengünstig gemeinsam erzeugt werden können. Aufgrund der gemeinsamen Strukturierung können dann sowohl die ersten als auch die zweiten Stege die gleiche überhängende Kantenform aufweisen. In diesem Fall kann vorteilhafterweise derjenige erste streifenförmige Steg, der zu den zweiten Elektrodenanschlußstücken 25B benachbart ist, derart gestaltet sein, daß er aus nicht miteinander verbundenen Bereichen 30 besteht, die den Steg in seiner Länge unterbrechen, wie beispielsweise in den Fig.4G und 4H gezeigt. Eine derartige Strukturierung ermöglicht nach wie vor ein Eingrenzen der funktionellen Schichten, verhindert allerdings auch ein durchgängiges Abreißen des Metallfilms an diesem ersten Steg beim Aufbringen der zweiten Elektrodenschicht, so daß diese weiterhin die zweiten Elektrodenanschlußstücke kontaktieren kann. Es ist auch möglich, das diese nicht miteinander verbundenen Bereiche (30) quer zu der längsten Ausdehnung des ersten Steges verlaufen, wie in Fig. 4G gezeigt.

Die zweiten isolierenden Stege 15 werden in der Regel quer zu den ersten Elektrodenstreifen 5 strukturiert. Als Materialien für die ersten und zweiten streifenförmigen Stege kommen prinzipiell alle strukturierbaren isolierenden Materialien in Betracht. So ist es beispielsweise möglich, positive oder negative Fotolacke einzusetzen, diese großflächig auf das Substrat 1 nach der Strukturierung der ersten Elektrodenstreifen aufzubringen und diese anschließend zu belichten und mit Hilfe eines Entwicklers zu entwickeln. Möglich ist es beispielsweise aber auch, andere isolierende schichtbildende Materialien, wie beispielsweise Siliziumdioxid, einzusetzen, das anschließend durch eine Schattenmaske mit Hilfe eines ätzenden Plasmas strukturiert werden kann. Möglich ist beispielsweise auch der Einsatz von Polyimidkunststoffen, die durch eine Maske hindurch mittels spezifisch auf das Polyimid einwirkender Lösungsmittel strukturiert werden können. Weiterhin ist es möglich, das isolierende Material sowohl der ersten als auch der zweiten isolierenden Stege mittels eines Druckverfahrens aufzubringen.

Prinzipiell ist es auch möglich, daß nur die ersten isolierenden streifenförmigen Stege 10 die funktionellen Schichten eingrenzen und dabei auch zumindest einen Großteil der zweiten streifenförmigen Stege 15 zur Kathodenseparation umgrenzen. Möglich ist es beispielsweise aber neben der erfindungsgemäßen Ausgestaltung der ersten streifenförmigen Stege auch, daß erste streifenförmige Stege, die quer zu den zweiten streifenförmigen Stegen stehen, zusammen mit wenigstens zwei dieser zweiten streifenförmigen Stege eine zusammenhängende Stegstruktur bilden, die funktionellen Schichten eingrenzt, wie beispielsweise in Figur 4C gezeigt.

Anschließend können wie in Figur 3C gezeigt, im Verfahrensschritt C) großflächig die funktionellen Schichten 20 aufgebracht werden. Zum großflächigen Aufbringen der funktionellen Schichten 20 eignen sich beispielsweise großflächige Druckverfahren, wie der Offsetdruck, Siebdruck, Tampondruck, Tief- und Hochdruckverfahren insbesondere der Flexodruck. Beim Flexodruck handelt es sich um ein Rollenrotationsdruckverfahren, bei dem beispielsweise flexible Druckvorlagen aus Gummi oder Kunststoff eingesetzt werden können.

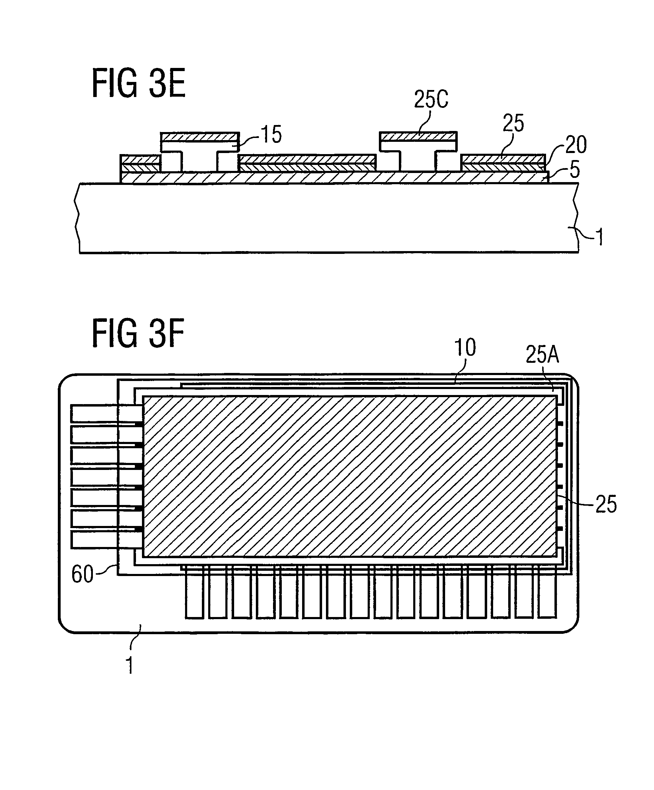

Im Verfahrensschritt D) wird anschließend wie in Figur 3D gezeigt, großflächig die zweite Elektrodenschicht 25A beispielsweise durch eine Schattenmaske aufgebracht, wobei der Metallfilm an den zweiten streifenförmigen Stegen abreißt, so daß die zweiten Elektrodenstreifen 25 gebildet werden, die beidseitig von je einem Steg der zweiten isolierenden Schicht begrenzt werden. Fig. 3 E zeigt ein OLED-Display im Querschnitt nach dem großflächigen Aufbringen der zweiten Elektrodenschicht im Verfahrensschritt D), wobei die zweiten Elektrodenstreifen 25 erzeugt werden. Dabei wird beim Abreißen des Metallfilms auch eine Metallschicht 25C auf der Kappe der zweiten Stege 15 erzeugt, die keinen Kontakt zu den zweiten Elektrodenstreifen hat. Die zweiten Elektrodenstreifen kontaktieren die zweiten Elektrodenanschlußstücke 25B. In einem letzten Verfahrensschritt E) wird abschließend wie in Figur 3F gezeigt, eine Abdeckung 60 angebracht, die die funktionellen Schichten, die darauf befindlichen zweiten Elektrodenstreifen 25 sowie je ein Ende der ersten und zweiten Elektrodenanschlußstücke bedeckt.

Da auch bei diesem erfindungsgemäßen Verfahren zur Herstellung eines Passiv-Matrix-Displays die funktionellen Schichten entweder nur durch die ersten streifenförmigen Stege 10 oder durch eine Kombination aus den ersten 10 und zweiten streifenförmigen Stegen 15 begrenzt werden, ist auch in diesem Fall auf einfache Weise eine dichte Abdeckung 60 des Displays möglich.

Bei diesem erfindungsgemäßen Verfahren sind eine Vielzahl von Kombinationen von ersten und zweiten streifenförmigen Stegen möglich. Werden die ersten streifenförmigen Stege vor den zweiten streifenförmigen Stegen separat strukturiert, so ist es möglich, durchgehende erste Stegstrukturen ohne überhängende Kantenformen zu strukturieren, wie in Figur 4B bis 4F gezeigt. Dabei ist es möglich, daß nur die ersten streifenförmigen Stege eine zusammenhängende Stegstruktur bilden, die die funktionellen Schichten begrenzt, wie in Figur 4B gezeigt. Dann ist es neben der erfindungsgemäßen Ausgestaltung der ersten streifenförmigen Stege weiterhin auch möglich, daß nur zwei erste streifenförmige Stege 10 die senkrecht zu den zweiten streifenförmigen Stegen stehen, zusammen mit wenigstens zwei dieser äußersten streifenförmigen zweiten Stege eine zusammenhängende Stegstruktur formen, die die funktionellen Schichten begrenzt, wie in Fig. 4C gezeigt. Wie bereits erwähnt, ist es auch möglich, daß die ersten streifenförmigen Stege 10 von weiteren streifenförmigen, ringförmig geschlossenen Stegen 35 umgeben werden, die einen zusätzlichen Schutz vor dem Verlaufen der funktionellen Schichten bieten (siehe Fig. 4D). In Figur 4F ist als weitere Ausführungsform neben den erfindungsgemäßen Ausführungsformen gezeigt, daß eine innere Begrenzung bestehend aus zwei ersten und zwei zweiten streifenförmigen Stegen ebenfalls von wenigstens vier weiteren Stegen 35 umgeben werden kann.

Werden die ersten und zweiten streifenförmigen Stege gemeinsam strukturiert, so ist es vorteilhaft, daß aufgrund der überhängenden Kantenform der strukturierten Stege derjenige erste streifenförmige Steg, der in Nachbarschaft zu den zweiten Elektrodenstreifen 25B steht, aus unterbrochenen Bereichen 30 besteht, so daß ein Abreißen des Metallfilms an diesem ersten Steg verhindert werden kann. Dabei ist es möglich, daß die Bereiche 30 quer zu den zweiten streifenförmigen Stegen stehen, wie in Figur 4G gezeigt oder daß sie senkrecht zu den zweiten streifenförmigen Stegen stehen, wobei parallel versetzte Strukturen möglich sind, wie in Figur 4H gezeigt. Möglich ist es dabei auch, daß mehrere parallel zueinander befindliche Stegstrukturen aufgebaut werden können, die jeweils senkrecht oder schräg zu den zweiten streifenförmigen Stegen stehen, wie in den Figuren 4I bis 4J gezeigt.

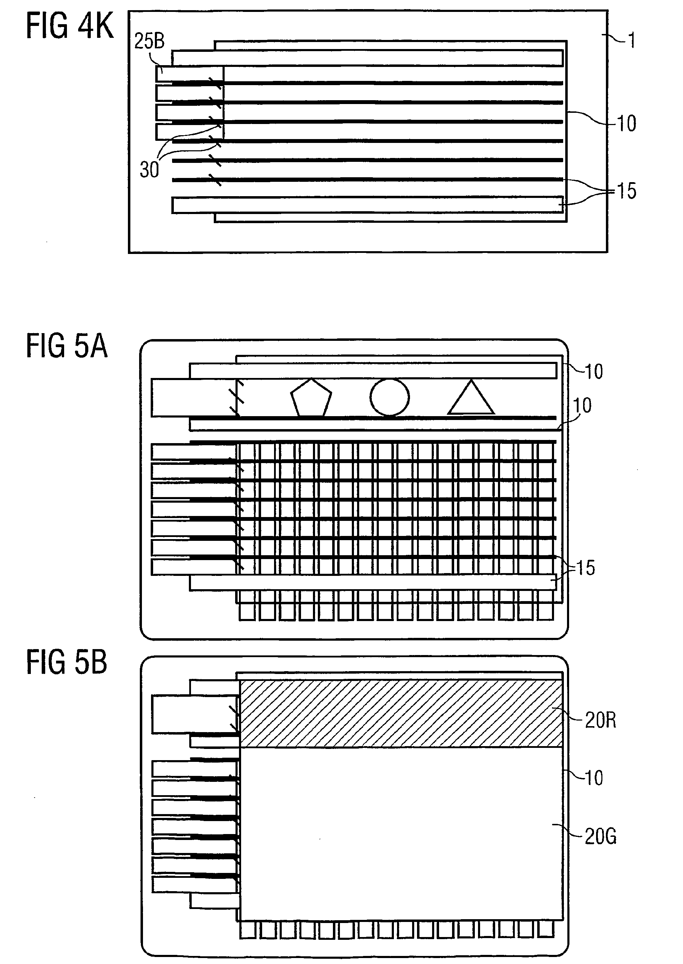

Vorteilhafterweise werden die zweiten streifenförmigen Stege auch über den Bereich der funktionellen Schichten und der sie begrenzenden ersten isolierenden Stege hinausgeführt, wie in den Figuren 4K und 4B bis 4F gezeigt, wobei in diesem Fall die zweiten Elektrodenanschlußstücke 25B zwischen den zweiten streifenförmigen Stege hindurchgeführt werden.
Die in Fig. 4K gezeigte Variante mit den zu den zweiten Stegen quer strukturierten unterbrochenen Bereichen 30 ist dabei auch für die anderen in den Fig. 4G bis 4J gezeigten Beispiele mit unterbrochenen Stegstrukturen möglich.

In Figur 5A ist ein erfindungsgemäßes Passiv-Matrix-Display mit einer Iconbar (Symbolleiste) vor dem Aufbringen der funktionellen Schichten 20 zu sehen. Bei dieser Variante grenzen die ersten streifenförmigen Stege 10 auch Bereiche ab, in die funktionelle Schichten 20R und 20G mit verschiedenfarbiger Elektrolumineszenz aufgetragen werden können, wie in Figur 5B gezeigt. Dadurch ist es beispielsweise möglich, die Symbolleiste mit funktionellen Schichten zu versehen, die in einer anderen Farbe elektrolumineszieren als der Rest des Displays.

In der Figur 6A sind einige beispielhafte Querschnitte von ersten isolierenden Stegen 10 ohne überhängende Kantenform gezeigt. Diese Kantenformen ermöglichen ein zuverlässiges Eingrenzen der funktionellen Schichten 20, verhindern gleichzeitig aber auch ein Abreißen des Metallfilms beim Aufbringen der zweiten Elektrodenschicht.

In Figur 6B sind einige beispielhafte Querschnitte von Stegen mit überhängender Kantenform zu sehen. Diese werden vorteilhafterweise bei den zweiten isolierenden Stegen zur Separation der Kathodenstreifen realisiert. Bei einem möglichen gemeinsamen Strukturieren der ersten und zweiten streifenförmigen Stege aus dem gleichen Material, werden auch häufig die ersten streifenförmigen Stege zur Eingrenzung der Polymere mit überhängenden Kantenformen ausgebildet. In diesem Falle ist es dann, wie bereits erwähnt, vorteilhaft, die in Figur 4G bis 4K gezeigte unterbrochene Form für denjenigen ersten isolierenden Stege auszubilden, die zu den zweiten Elektrodenstreifen 25B benachbart sind.

Die erfindungsgemäßen Stegstrukturen zur Eingrenzung der funktionellen Schichten können bei verschiedenen Bauformen von OLED-Displays verwendet werden, bei denen z.B. wegen einer Abdeckung ein Verlaufen der funktionellen Schichten vermieden werden sollte. Dazu zählen beispielsweise auch Aktiv-Matrix-Bildschirme.

In Figur 7 ist ein beispielhafter Aufbau eines erfindungsgemäßen Aktiv-Matrix-Displays mit ersten streifenförmigen isolierenden Stegen 10 zur Eingrenzung der funktionellen Schichten 20 zu sehen. Bei einem Aktiv-Matrix-Display wird vorteilhafterweise eine Matrix einzeln ansteuerbarer Bildpunkte dadurch geschaffen, daß jeder Bildpunkt mit mindestens einem einzeln ansteuerbaren Halbleiterbauelement 40, beispielsweise einem Transistor, versehen ist, der mit einer ersten Elektrode 45 elektrisch leitend verbunden ist und neben den Fenstern 50 unter einer isolierenden Schicht 70 angeordnet ist. Die isolierende Schicht 70 ermöglicht ein scharfes Abgrenzen der einzelnen Bildpunkte voneinander und grenzt die Halbleiterbauelemente von den funktionellen Polymeren ab. Auf die Fensterstruktur mit den darin befindlichen Halbleiterbauelementen und ersten Elektroden können großflächig die funktionellen Schichten 20 und darauf großflächig eine zweite Elektrodenschicht 55 angeordnet werden. Die zweite Elektrodenschicht 55 kann erfindungsgemäß wie in den vorherigen Ausführungsbeispielen auf zumindest einem der ersten streifenförmigen Stege 10 angeordnet sein (der Übersichtlichkeit halber nicht gezeigt).

Im Falle eines transparenten Substrates kann auf der dem Betrachter zugewandten Seite des Substrats 1 häufig ein Spiegel- und/oder Blendeffekt auftreten, der den Blick durch das transparente Substrat auf die OLED empfindlich stören kann und als nachteilig empfunden wird. Diese Reflexion läßt sich dadurch vermindern, daß zumindest Teilbereiche auf derjenigen Seite des transparenten Substrats 1, die dem Betrachter zugewandt sind, aufgerauht werden, beispielsweise durch Sandbestrahlung einer Glasplatte, so daß es zu einer Mattierung des Substrates kommt. Die Mattierung wird durch mikroskopisch kleine Vertiefungen in der Oberfläche erzeugt. Jede solche Vertiefung wirkt für sich als Streuzentrum für das emittierte Licht. Durch die diffuse Verteilung des Lichts wird der störende Blend- und/oder Spiegeleffekt beseitigt.

Es ist möglich, daß einige Stege der zweiten isolierenden Schicht auch grafische Elemente des Displays strukturieren. Da diese Stege vorteilhafterweise eine überhängende Kantenform aufweisen, lassen sich beispielsweise geschlossene Umrisse von grafischen Elementen mit Teilen dieser Stege strukturieren, die anschließend einen Bereich einschließen, der vom Rest der zweiten Elektrodenschicht isoliert werden kann und daher nicht leuchtet und dunkel erscheint.

Die Erfindung ist nicht auf die konkret beschriebenen Ausführungsbeispiele beschränkt. Im Rahmen der Erfindung liegen selbstverständlich auch weitere Variationen insbesondere bzgl. der verwendeten Materialien für die Stege zur Eingrenzung der funktionellen Schichten, der Geometrie des Displays und der genauen Verfahrensschritte zur Herstellung des Displays. Möglich ist beispielsweise auch ein Display, das aus einem nicht transparentem Substrat mit einer nicht transparenten ersten Elektrodenschicht besteht, wobei in diesem Fall die zweite Elektrodenschicht und die Abdeckung transparent sind, um eine Lichtabstrahlung des Displays zu ermöglichen.

## Patentansprüche

1. Organisches, elektrolumineszierendes Display mit den Merkmalen:
- auf einem Substrat (1) ist eine erste Elektrodenschicht (5A) angeordnet,
- erste streifenförmige Stege (10) grenzen einen zusammenhängenden Bereich ein, in dem funktionelle Schichten (20) auf der ersten Elektrodenschicht (5A) großflächig angeordnet sind, wobei die funktionellen Schichten (20) ausschließlich innerhalb des von den ersten streifenförmigen Stegen (10) begrenzten zusammenhängenden Bereichs vorhanden sind und die ersten streifenförmigen Stege (10) den zusammenhängenden Bereich gänzlich umschließen, charakterisiert **dadurch**, dass
eine zweite Elektrodenschicht (25A) auf den funktionellen Schichten (20) und auf zumindest einem der ersten streifenförmigen Stege (10) angeordnet ist.

2. Display nach dem vorhergehenden Anspruch mit den Merkmalen:
- die erste Elektrodenschicht (5A) ist elektrisch leitend mit einem ersten Elektrodenanschlußstück (5B) verbunden,
- neben der ersten Elektrodenschicht und elektrisch isoliert von dieser ist auf dem Substrat (1) zumindest ein zweites Elektrodenanschlußstück (25B) angeordnet,
- die zweite Elektrodenschicht (25A) kontaktiert das zweite Elektrodenanschlußstück (5B),
- eine Abdeckung (60) bedeckt den Bereich der funktionellen Schichten (20) und der sie eingrenzenden Stege (10), die zweite Elektrodenschicht (25A), sowie jeweils ein Ende des ersten und zweiten Elektrodenanschlußstückes (5B und 25B).

3. Organisches, elektrolumineszierendes Display nach einem der vorhergehenden Ansprüche,
- bei dem die erste Elektrodenschicht (5A) zueinander parallel verlaufende erste Elektrodenstreifen (5) umfaßt, wobei die Verlängerung eines jeden Elektrodenstreifens (5) als Elektrodenanschlußstück (5B) dient,
- bei dem zweite isolierende streifenförmige Stege (15) quer zu den ersten Elektrodenstreifen (5) angeordnet sind,
- bei dem die ersten streifenförmigen Stege (10) alleine oder zusammen mit wenigstens zwei der zweiten, streifenförmigen Stege (10) die funktionellen Schichten (20) eingrenzen,
- bei dem die zweite Elektrodenschicht (25A) zweite Elektrodenstreifen (25) umfaßt, die quer zu den ersten Elektrodenstreifen (5) angeordnet sind und beidseitig von je einem zweiten isolierenden Steg (15) begrenzt werden.

4. Display nach Anspruch 3,
- bei dem zumindest zwei erste isolierende Stege (10) quer zu den zweiten isolierenden Stegen (15) angeordnet sind und zusammen mit wenigstens zweien dieser Stege (15) die funktionellen Schichten (20) eingrenzen.

5. Display nach einem der vorherigen Ansprüche,
- bei dem die ersten isolierenden Stege (10) durch parallel dazu verlaufende, weitere streifenförmige Stege (35) umschlossen sind.

6. Display nach einem der Ansprüche 3 bis 5,
- bei dem wenigstens zwei erste isolierende Stege quer und zwei weitere erste Stege längs zu den zweiten isolierenden Stegen (15) verlaufen, wobei die vier Stege zusammen die funktionellen Schichten (20) und die streifenförmigen zweiten isolierenden Stege (15) eingrenzen.

7. Display nach dem vorhergehenden Anspruch,
- bei dem die vier ersten streifenförmigen Stege (10) von wenigstens vier weiteren streifenförmigen Stegen (35) eingegrenzt werden.

8. Display nach einem der Ansprüche 3 bis 7,
- bei dem die ersten und zweiten streifenförmigen Stege aus dem gleichen Material ausgebildet sind.

9. Display nach einem der Ansprüche 4 bis 8,
- bei dem wenigstens einer der ersten isolierenden Stege (10), der quer zu den zweiten isolierenden Stegen (15) angeordnet ist, aus wenigstens zwei, nicht miteinander verbundenen Bereichen (30) ausgebildet ist, die den Steg in seiner Länge unterbrechen.

10. Display nach dem vorherigen Anspruch,
- bei dem die nicht miteinander verbundenden Bereiche (30) quer zu der Länge des ersten Stegs verlaufen.

11. Display nach einem der Ansprüche 3 bis 10,
- bei dem die zweiten isolierenden streifenförmigen Stege (15) im Querschnitt eine überhängende Kantenform aufweisen.

12. Display nach einem der Ansprüche 3 bis 11,
- bei dem die ersten isolierenden Stege (10) funktionelle Schichten (20R, 20G) voneinander abgrenzen, die verschiedenfarbige Elektrolumineszenz zeigen.

13. Display nach einem der Ansprüche 3 bis 12,
- bei dem zumindest einige Stege graphische Elemente des Displays strukturieren.

14. Display nach einem der vorherigen Ansprüche,
- bei dem das Substrat (1) transparent ist und auf einer, dem Betrachter zugewandten Seite zumindest in Teilbereichen mattiert ist.

15. Display nach Anspruch 1, wobei das Display als Aktiv-Matrix-Display ausgeführt ist mit den weiteren Merkmalen:
- auf dem Substrat (1) ist eine Matrix einzeln ansteuerbarer Halbleiterbauelemente (40) mit ersten Elektroden (45) vorgesehen, wobei die Halbleiterbauelemente neben Fenstern (50) unter einer isolierenden Schicht (70) angeordnet sind und jeweils die großflächig auf die isolierende Schicht und deren Fenster aufgebrachten funktionellen Schichten (20) kontaktieren und jeweils einen Bildpunkt des Displays definieren,
- die streifenförmigen ersten isolierenden Stege (10) sind um die isolierende Schicht (70) herum angeordnet und begrenzen die großflächig angeordneten funktionellen Schichten (20), und
- auf den funktionellen Schichten ist großflächig die zweite Elektrodenschicht (55) angeordnet.

16. Verfahren zur Herstellung eines organischen, elektrolumineszierenden Displays mit den Verfahrensschritten,
A) auf einem Substrat (1) wird eine erste Elektrodenschicht (5A) erzeugt,
B) eine erste isolierende Schicht wird auf das Substrat und/oder die erste Elektrodenschicht (5A) aufgebracht und anschließend so zu streifenförmigen Stegen (10) strukturiert, daß diese einen für funktionelle Schichten (20) vorgesehenen zusammenhängenden Bereich eingrenzen und gänzlich umschließen,
C) anschließend werden die funktionellen Schichten (20) großflächig ausschließlich in dem genannten Bereich aufgebracht,
D) danach wird großflächig eine zweite Elektrodenschicht (25A) auf den funktionellen Schichten (20) und zumindest einem der streifenförmigen Stege (10) erzeugt.

17. Verfahren nach dem vorhergehenden Anspruch,
- bei dem im Verfahrensschritt A) zusätzlich ein erstes Elektrodenanschlußstück (5B), das elektrisch leitend mit der ersten Elektrodenschicht (5A) verbunden ist und daneben zumindest ein zweites Elektrodenanschlußstück (25B)erzeugt werden,
- bei dem im Verfahrensschritt D) die zweite Elektrodenschicht (25A) so erzeugt wird, daß sie das zweite Elektrodenanschlußstück (25B) kontaktiert,
- bei dem in einem nach dem Verfahrensschritt D) stattfindenden Verfahrensschritt E) anschließend eine Abdeckung (60) so angebracht wird, daß sie den Bereich der funktionellen Schichten (20) und der sie eingrenzenden Stege (10), die zweite Elektrodenschicht (25A) und jeweils ein Ende des ersten und zweiten Elektrodenanschlußstückes bedeckt.

18. Verfahren nach dem vorherigen Anspruch,
- bei dem im Verfahrensschritt A) die erste Elektrodenschicht (5A) zu zueinander parallel verlaufenden ersten Elektrodenstreifen (5) strukturiert wird,
- bei dem im Verfahrensschritt B) zusätzlich zu den Stegen (10) der ersten isolierenden Schicht eine zweite isolierende Schicht zu Stegen (15) quer zu den ersten Elektrodenstreifen (5) strukturiert wird,
- bei dem im Verfahrensschritt D) die zweite Elektrodenschicht (25A) so aufgetragen wird, daß zweite Elektrodenstreifen (25) erzeugt werden, deren Längsseiten von je einem Steg (15) der zweiten isolierenden Schicht begrenzt werden.

19. Verfahren nach dem vorherigen Anspruch,
- bei dem im Verfahrensschritt B) die erste und zweite isolierende Schicht gleichzeitig strukturiert werden.

20. Verfahren nach Anspruch 18,
- bei dem in einem separaten Verfahrenschritt B1) die zweite isolierende Schicht vor oder nach der ersten isolierenden Schicht strukturiert wird.

21. Verfahren nach dem vorhergehenden Anspruch,
- bei dem diejenigen Stege (10 oder 15), die zuerst strukturiert wurden, nach ihrer Strukturierung durch eine zusätzliche Behandlung ihrer Oberfläche modifiziert werden, bevor die anderen Stege erzeugt werden.

22. Verfahren nach dem vorhergehenden Anspruch,
- bei dem als zusätzliche Behandlung eine Passivierung gegenüber Benetzung durch Ätzen mit einem fluorierenden Plasma erfolgt.

23. Verfahren nach Anspruch 21,
- bei dem die zusätzliche Behandlung in einer chemischen Behandlung mit grenzflächenaktiven Stoffen oder chemischen Härtern besteht.

24. Verfahren nach einem der Ansprüche 18 bis 23,
- bei dem die zweite isolierende Schicht so strukturiert wird, daß wenigstens zwei Stege (15) dieser Schicht gemeinsam mit den Stegen (10) der ersten isolierenden Schicht den Bereich eingrenzen, auf dem später die funktionellen Schichten erzeugt werden.

25. Verfahren nach einen der Ansprüche 16 bis 24,
- bei dem die erste und/oder zweite isolierende Schicht aus einem Photolack ausgebildet wird.

26. Verfahren nach einem der Ansprüche 18 bis 25,
- bei dem die erste und/oder zweite isolierende Schicht aus einem schichtbildenen isolierenden Material ausgebildet wird.

27. Verfahren nach einem der Ansprüche 18 bis 26,
- bei dem die erste und/oder zweite isolierende Schicht mittels eines Druckverfahrens aufgebracht werden.

28. Verfahren nach einem der Ansprüche 16 bis 27,
- bei dem die erste und/oder zweite isolierende Schicht im Verfahrenschritt B) und/oder B1) **dadurch** strukturiert werden, daß sie entweder
- durch eine Maske hindurch mit Plasma geätzt werden oder
- belichtet und anschließend geätzt werden oder
- einem spezifisch auf die erste und/oder zweite isolierende Schicht einwirkenden Lösungsmittel ausgesetzt werden.

29. Verfahren nach einem der Ansprüche 18 bis 28,
- bei dem die erste und zweite isolierende Schicht aus einem unterschiedlichen Material ausgebildet werden.

30. Verfahren nach einem der Ansprüche 16 bis 29,
- bei dem im Verfahrensschritt C) die funktionellen Schichten (20) durch großflächige Druckverfahren aufgebracht werden.

31. Verfahren nach dem vorhergehenden Anspruch,
- bei dem die funktionellen Schichten durch Offsetdruck, Siebdruck, Tampondruck,Tief- und Hochdruckverfahren, insbesondere Flexodruck erzeugt werden.

32. Verfahren nach einem der Ansprüche 16 bis 31,
- bei dem das Substrat (1) transparent ist und vor dem Verfahrensschritt A) auf der dem Betrachter zugewandten Seite aufgerauht wird.

33. Verfahren nach einem der Ansprüche 16 bis 32,
- bei dem zu den ersten isolierenden Stegen (10) parallel verlaufende, weitere streifenförmige Stege (35) aufgebracht werden, wobei die ersten isolierenden Stege (10) durch die weiteren streifenförmigen Stege (35) umschlossen sind.

## Claims

1. Organic electroluminescent display comprising the following features:
- a first electrode layer (5A) is arranged on a substrate (1),
- first strip-type webs (10) delimit a continuous region in which functional layers (20) are arranged on the first electrode layer (5A) in a large-area fashion, the functional layers (20) being present exclusively within the continuous region bounded by the first strip-type webs (10) and the first strip-type webs (10) completely enclosing the continuous region, **characterized in that**
a second electrode layer (25A) is arranged on the functional layers (20) and on at least one of the first strip-type webs (10).

2. Display according to the preceding claim comprising the following features:
- the first electrode layer (5A) is electrically conductively connected to a first electrode connection piece (5B),
- at least one second electrode connection piece (25B) is arranged on the substrate (1) alongside the first electrode layer and in a manner electrically insulated from the latter,
- the second electrode layer (25A) makes contact with the second electrode connection piece (5B),
- a covering (60) covers the region of the functional layers (20) and of the webs (10) delimiting the functional layers (20), the second electrode layer (25A), and also a respective end of the first and second electrode connection pieces (5B and 25B).

3. Organic electroluminescent display according to either of the preceding claims,
- wherein the first electrode layer (5A) comprises first electrode strips (5) running parallel to one another, the extension of each electrode strip (5) serving as electrode connection piece (5B),
- wherein second insulating strip-type webs (15) are arranged transversely with respect to the first electrode strips (5),
- wherein the first strip-type webs (10) alone or together with at least two of the second strip-type webs (10) delimit the functional layers (20),
- wherein the second electrode layer (25A) comprises second electrode strips (25), which are arranged transversely with respect to the first electrode strips (5) and are bounded on both sides by a respective second insulating web (15).

4. Display according to Claim 3,
- wherein at least two first insulating webs (10) are arranged transversely with respect to the second insulating webs (15) and together with at least two of said webs (15) delimit the functional layers (20).

5. Display according to any of the preceding claims,
- wherein the first insulating webs (10) are enclosed by further strip-type webs (35) running parallel thereto.

6. Display according to any of Claims 3 to 5,
- wherein at least two first insulating webs run transversely and two further first webs run longitudinally with respect to the second insulating webs (15), the four webs together delimiting the functional layers (20) and the strip-type second insulating webs (15).

7. Display according to the preceding claim,
- wherein the four first strip-type webs (10) are delimited by at least four further strip-type webs (35).

8. Display according to any of Claims 3 to 7,
- wherein the first and second strip-type webs are formed from the same material.

9. Display according to any of Claims 4 to 8,
- wherein at least one of the first insulating webs (10) which is arranged transversely with respect to the second insulating webs (15) is formed from at least two regions (30) which are not connected to one another and which interrupt the web in its length.

10. Display according to the preceding claim,
- wherein the regions (30) which are not connected to one another run transversely with respect to the length of the first web.

11. Display according to any of Claims 3 to 10,
- wherein the second insulating strip-type webs (15) have an overhanging edge form in cross section.

12. Display according to any of Claims 3 to 11,
- wherein the first insulating webs (10) delimit from one another functional layers (20R, 20G) which exhibit different-coloured electroluminescence.

13. Display according to any of Claims 3 to 12,
- wherein at least some webs structure graphical elements of the display.

14. Display according to any of the preceding claims,
- wherein the substrate (1) is transparent and is matted at least in partial regions on a side facing the observer.

15. Display according to Claim 1, the display being embodied as an active matrix display, comprising the following further features:
- a matrix of individually drivable semiconductor components (40) with first electrodes (45) is provided on the substrate (1), the semiconductor components being arranged alongside windows (50) below an insulating layer (70) and respectively making contact with the functional layers (20) which are applied in large-area fashion to the insulating layer and the windows thereof, and respectively defining a pixel of the display,
- the strip-type first insulating webs (10) are arranged around the insulating layer (70) and bound the functional layers (20) arranged in large-area fashion, and
- the second electrode layer (55) is arranged on the functional layers in large-area fashion.

16. Method for producing an organic electroluminescent display comprising the following method steps:
A) a first electrode layer (5A) is produced on a substrate (1),
B) a first insulating layer is applied to the substrate and/or the first electrode layer (5A) and subsequently structured to form strip-type webs (10) in such a way that the latter delimit and completely enclose a continuous region provided for functional layers (20),
C) afterwards, the functional layers (20) are applied in large-area fashion exclusively in the above-mentioned region,
D) subsequently, a second electrode layer (25A) is produced in large-area fashion on the functional layers (20) and at least one of the strip-type webs (10).

17. Method according to the preceding claim,
- wherein, in method step A), additionally a first electrode connection piece (5B), which is electrically conductively connected to the first electrode layer (5A), and in addition at least one second electrode connection piece (25B) are produced,
- wherein, in method step D), the second electrode layer (25A) is produced in such a way that it makes contact with the second electrode connection piece (25B),
- wherein, in a method step E), which takes place after method step D), a covering (60) is subsequently fitted in such a way that it covers the region of the functional layers (20) and of the webs (10) delimiting them, the second electrode layer (25A), and a respective end of the first and second electrode connection pieces.

18. Method according to the preceding claim,
- wherein, in method step A), the first electrode layer (5A) is structured to form first electrode strips (5) running parallel to one another,
- wherein, in method step B), in addition to the webs (10) of the first insulating layer, a second insulating layer is structured to form webs (15) transversely with respect to the first electrode strips (5),
- wherein, in method step D), the second electrode layer (25A) is applied in such a way that second electrode strips (25) are produced, the longitudinal sides of which are bounded by a respective web (15) of the second insulating layer.

19. Method according to the preceding claim,
- wherein, in method step B), the first and second insulating layers are structured simultaneously.

20. Method according to Claim 18,
- wherein, in a separate method step B1), the second insulating layer is structured before or after the first insulating layer.

21. Method according to the preceding claim,
- wherein those webs (10 or 15) which were structured first are modified after their structuring by means of an additional treatment of their surface before the other webs are produced.

22. Method according to the preceding claim,
- wherein the additional treatment effected is a passivation with respect to wetting by means of etching using a fluorinating plasma.

23. Method according to Claim 21,
- wherein the additional treatment consists in a chemical treatment with surface-active substances or chemical hardeners.

24. Method according to any of Claims 18 to 23,
- wherein the second insulating layer is structured in such a way that at least two webs (15) of this layer together with the webs (10) of the first insulating layer delimit the region on which the functional layers are subsequently produced.

25. Method according to any of Claims 16 to 24,
- wherein the first and/or second insulating layer(s) are/is formed from a photoresist.

26. Method according to any of Claims 18 to 25,
- wherein the first and/or second insulating layer(s) are/is formed from a layer-forming insulating material.

27. Method according to any of Claims 18 to 26,
- wherein the first and/or second insulating layer(s) are/is applied by means of a printing method.

28. Method according to any of Claims 16 to 27,
- wherein the first and/or second insulating layer(s) are/is structured in method step B) and/or B1) by virtue of the fact that they are either
- etched through a mask using plasma or
- exposed and subsequently etched or
- subjected to a solvent that acts specifically on the first and/or second insulating layer(s).

29. Method according to any of Claims 18 to 28,
- wherein the first and second insulating layers are formed from a different material.

30. Method according to any of Claims 16 to 29,
- wherein, in method step C), the functional layers (20) are applied by means of large-area printing methods.

31. Method according to the preceding claim,
- wherein the functional layers are produced by offset printing, screen printing, pad printing, intaglio printing and relief printing methods, in particular flexographic printing.

32. Method according to any of Claims 16 to 31,
- wherein the substrate (1) is transparent and, before method step A), is roughened on the side facing the observer.

33. Method according to any of Claims 16 to 32,
- wherein further strip-type webs (35) running parallel to the first insulating webs (10) are applied, the first insulating webs (10) being enclosed by the further strip-type webs (35).

## Revendications

1. Afficheur électroluminescent organique ayant les caractéristiques suivantes :
- une première couche d'électrode (5A) est disposée sur un substrat (1),
- des premières âmes (10) en forme de bandes délimitent une zone cohérente dans laquelle des couches fonctionnelles (20) sont disposées sur une grande surface de la première couche d'électrode (5A), les couches fonctionnelles (20) étant exclusivement présentes à l'intérieur de la zone cohérente délimitée par les premières âmes (10) en forme de bandes et les premières âmes (10) en forme de bandes entourant entièrement la zone cohérente, **caractérisé en ce que** une deuxième couche d'électrode (25A) est disposée sur les couches fonctionnelles (20) et sur au moins l'une des premières âmes (10) en forme de bandes.

2. Afficheur selon la revendication précédente ayant les caractéristiques suivantes :
- la première couche d'électrode (5A) est reliée électriquement avec une première pièce de raccordement d'électrode (5B),
- au moins une deuxième pièce de raccordement d'électrode (25B) est disposée sur le substrat (1) à côté de la première couche d'électrode et isolée électriquement de celle-ci,
- la deuxième couche d'électrode (25A) est en contact avec la deuxième pièce de raccordement d'électrode (25B),
- un couvercle (60) recouvre la zone des couches fonctionnelles (20) et des âmes (10) qui les délimitent, la deuxième couche d'électrode (25A) et respectivement une extrémité de la première et de la deuxième pièce de raccordement d'électrode (5B et 25B).

3. Afficheur électroluminescent organique selon l'une des revendications précédentes :
- avec lequel la première couche d'électrode (5A) comprend des premières bandes d'électrode (5) qui s'étendent parallèlement les unes aux autres, la prolongation de chaque bande d'électrode (5) servant de pièce de raccordement d'électrode (5B),
- avec lequel des deuxièmes âmes (15) en forme de bandes isolantes sont disposées transversalement par rapport aux premières bandes d'électrode (5),
- avec lequel les premières âmes (10) en forme de bandes délimitent les couches fonctionnelles (20) seules ou conjointement avec au moins deux des deuxièmes âmes (15) en forme de bandes,
- avec lequel la deuxième couche d'électrode (25A) comprend des deuxièmes bandes d'électrode (25) qui sont disposées transversalement par rapport aux premières bandes d'électrode (5) et qui sont délimitées des deux côtés à chaque fois par une deuxième âme isolante (15).

4. Afficheur selon la revendication 3,
- avec lequel au moins deux premières âmes isolantes (10) sont disposées transversalement par rapport aux deuxièmes âmes isolantes (15) et, conjointement avec au moins deux de ces âmes (15), délimitent les couches fonctionnelles (20).

5. Afficheur selon l'une des revendications précédentes,
- avec lequel les premières âmes isolantes (10) sont entourées par des âmes (35) en forme de bandes supplémentaires qui s'étendent parallèlement à celles-ci.

6. Afficheur selon l'une des revendications 3 à 5,
- avec lequel au moins deux premières âmes isolantes s'étendent transversalement et deux premières âmes isolantes supplémentaires longitudinalement par rapport aux deuxièmes âmes isolantes (15), les quatre âmes délimitant conjointement les couches fonctionnelles (20) et les deuxièmes âmes isolantes (15) en forme de bandes.

7. Afficheur selon l'une des revendications précédentes,
- avec lequel les quatre premières âmes (10) en forme de bandes sont délimitées par au moins quatre âmes (35) en forme de bandes supplémentaires.

8. Afficheur selon l'une des revendications 3 à 7,
- avec lequel les premières et les deuxièmes âmes en forme de bandes sont constituées du même matériau.

9. Afficheur selon l'une des revendications 4 à 8
- avec lequel au moins l'une des premières âmes isolantes (10), laquelle est disposée transversalement par rapport aux deuxièmes âmes isolantes (15), se compose d'au moins deux zones (30) non reliées entre elles qui interrompent la âme dans sa longueur.

10. Afficheur selon la revendication précédente,
- avec lequel les zones (30) non reliées entre elles s'étendent transversalement par rapport à la longueur de la première âme.

11. Afficheur selon l'une des revendications 3 à 10,
- avec lequel les deuxièmes âmes isolantes (15) en forme de bandes présentent, en section transversale, la forme d'une arête en surplomb.

12. Afficheur selon l'une des revendications 3 à 11,
- avec lequel les premières âmes isolantes (10) délimitent l'une par rapport à l'autre des couches fonctionnelles (20R, 20G) qui présentent une électroluminescence de couleur différente.

13. Afficheur selon l'une des revendications 3 à 12,
- avec lequel au moins quelques âmes structurent les éléments graphiques de l'afficheur.

14. Afficheur selon l'une des revendications précédentes,
- avec lequel le substrat (1) est transparent et rendu mat au moins dans des zones partielles sur un côté qui fait face à l'observateur.

15. Afficheur selon la revendication 1, l'afficheur étant réalisé sous la forme d'un afficheur à matrice active avec les caractéristiques supplémentaires suivantes :
- une matrice de composants semiconducteurs (40) munis de premières électrodes (45) est prévue sur le substrat (1), les composants semiconducteurs étant disposés à côté de fenêtres (50) sous une couche isolante (70) et étant respectivement en contact avec les couches fonctionnelles (20) disposées sur une grande surface sur la couche isolante et ses fenêtres et définissant à chaque fois un pixel de l'afficheur,
- les premières âmes isolantes (10) en forme de bandes sont disposées autour de la couche isolante (70) et délimitent les couches fonctionnelles (20) disposées sur une grande surface, et
- la deuxième couche d'électrode (55) est disposée sur une grande surface sur les couches fonctionnelles.

16. Procédé de fabrication d'un afficheur électroluminescent organique comprenant les étapes suivantes :
A) Production d'une première couche d'électrode (5A) sur un substrat (1),
B) Application d'une première couche isolante sur le substrat et/ou la première couche d'électrode (5A) et ensuite structuration de celle-ci en âmes (10) en forme de bandes de telle sorte que celles-ci délimitent et entourent entièrement une zone cohérente prévue pour les couches fonctionnelles (20),
C) Les couches fonctionnelles (20) sont ensuite appliquées sur une grande surface exclusivement dans ladite zone cohérente,
D) Une deuxième couche d'électrode (25A) de grande surface est ensuite produite sur les couches fonctionnelles (20) et sur au moins l'une des âmes (10) en forme de bandes.

17. Procédé selon la revendication précédente,
- avec lequel, dans l'étape A), sont produites une première pièce de raccordement d'électrode (5B), laquelle est reliée électriquement avec la première couche d'électrode (5A), et à côté de celle-ci au moins une deuxième pièce de raccordement d'électrode (25B),
- avec lequel, dans l'étape D), la deuxième couche d'électrode (25A) est produite de telle sorte qu'elle est en contact avec la deuxième pièce de raccordement d'électrode (25B),
- avec lequel, dans une étape E) qui a lieu immédiatement après l'étape D), un couvercle (60) est ensuite appliquée de telle sorte qu'elle recouvre la zone des couches fonctionnelles (20) et des âmes (10) qui les délimitent, la deuxième couche d'électrode (25A) et respectivement une extrémité de la première et de la deuxième pièce de raccordement d'électrode (5B et 25B).

18. Procédé selon la revendication précédente :
- avec lequel, dans l'étape A), la première couche d'électrode (5A) est structurée en premières bandes d'électrode (5) qui s'étendent parallèlement les unes aux autres,
- avec lequel, dans l'étape B), en plus des âmes (10) de la première couche isolante, une deuxième couche isolante est structurée en âmes (15) en forme de bandes transversalement par rapport aux premières bandes d'électrode (5),
- avec lequel, dans l'étape D), la deuxième couche d'électrode (25A) est appliquée de telle sorte que des deuxièmes bandes d'électrode (25) sont produites, lesquelles sont délimitées sur les côtés longs à chaque fois par une âme (15) de la deuxième couche isolante.

19. Procédé selon la revendication précédente,
- avec lequel, dans l'étape B), la première et la deuxième couches isolantes sont structurées simultanément.

20. Procédé selon la revendication 18,
- avec lequel, dans une étape séparée B1), la deuxième couche isolante est structurée avant ou après la première couche isolante.

21. Procédé selon la revendication précédente,
- avec lequel les âmes respectives (10 ou 15) qui ont été structurées en premier sont modifiées après leur structuration par un traitement supplémentaire de leur surface avant de produire les autres âmes.

22. Procédé selon la revendication précédente
- avec lequel le traitement supplémentaire effectué est une passivation contre l'imprégnation par gravure avec un plasma fluorescent.

23. Procédé selon la revendication 21,
- avec lequel le traitement supplémentaire se compose d'un traitement chimique avec des substances tensio-actives ou des durcisseurs chimiques.

24. Procédé selon l'une des revendications 18 à 23,
- avec lequel la deuxième couche isolante est structurée de telle sorte qu'au moins deux âmes (15) de cette couche, conjointement avec les âmes (10) de la première couche isolante, délimitent la zone sur laquelle seront ultérieurement produites les couches fonctionnelles.

25. Procédé selon l'une des revendications 16 à 24,
- avec lequel la première et/ou la deuxième couche isolante sont constituées de vernis photosensible.

26. Procédé selon l'une des revendications 18 à 25,
- avec lequel la première et/ou la deuxième couche isolante sont constituées d'un matériau isolant formant une couche.

27. Procédé selon l'une des revendications 18 à 26,
- avec lequel la première et/ou la deuxième couche isolante sont appliquées au moyen d'un procédé d'impression.

28. Procédé selon l'une des revendications 16 à 27,
- avec lequel la première et/ou la deuxième couche isolante sont structurées dans l'étape B) et/ou B1) en ce qu'elles sont
- gravées au plasma à travers un masque,
- insolées et ensuite gravées, ou
- exposées à un solvant qui agit spécifiquement sur la première et/ou la deuxième couche isolante.

29. Procédé selon l'une des revendications 18 à 28,
- avec lequel la première et la deuxième couche isolante sont constituées d'un matériau différent.

30. Procédé selon l'une des revendications 16 à 29,
- avec lequel, dans l'étape C), les couches fonctionnelles (20) sont appliquées par un procédé d'impression sur grande surface.

31. Procédé selon la revendication précédente,
- avec lequel les couches fonctionnelles sont produites par impression offset, sérigraphie, tamponnage, impression en taille douce et typographie, notamment flexographie.

32. Procédé selon l'une des revendications 16 à 31,
- avec lequel le substrat (1) est transparent et est rendu rugueux sur le côté qui fait face à l'observateur avant l'étape A).

33. Procédé selon l'une des revendications 16 à 32,
- avec lequel des âmes (35) en forme de bandes supplémentaires sont appliquées, lesquelles s'étendent parallèlement aux premières âmes isolantes (10), les premières âmes isolantes (10) étant entourées par les âmes (35) en forme de bandes supplémentaires.
